# EUROPEAN PATENT SPECIFICATION

(11) **EP 3 760 690 B1**
(45) Date of publication and mention of the grant of the patent: **17.05.2023**
(21) Application number: 20183117.9
(22) Date of filing: 30.06.2020
(51) Int. Cl.: C09K 11/61

(54) **LUMINESCENT COMPOUND, METHOD OF PREPARING THE SAME, AND LIGHT EMITTING DEVICE INCLUDING THE SAME**
LUMINESZIERENDE VERBINDUNG, VERFAHREN ZUR HERSTELLUNG DAVON UND LICHTEMITTIERENDE VORRICHTUNG DAMIT
COMPOSÉ LUMINESCENT, SON PROCÉDÉ DE PRÉPARATION ET DISPOSITIF ÉLECTROLUMINESCENT LE COMPRENANT

(30) Priority: 01.07.2019 KR 20190078956
(43) Date of publication of application: 06.01.2021
(73) Proprietor: Samsung Electronics Co., Ltd., Gyeonggi-do 16677 (KR)
(72) Inventor: KIM, Yong Churl, 16678 Gyeonggi-do (KR); CHUNG, Jongwon, 16678 Gyeonggi-do (KR)
(74) Representative: Elkington and Fife LLP

(56) References cited:
- WO-A1-2012/169659
- CN-A- 1 464 074
- TAEHWAN JUN ET AL: "Lead-Free Highly Efficient Blue-Emitting Cs 3 Cu 2 I 5 with 0D Electronic Structure", ADVANCED MATERIALS, vol. 30, no. 43, 14 September 2018 (2018-09-14), page 1804547, XP055739103, ISSN: 0935-9648, DOI: 10.1002/adma.201804547

## Description

### FIELD OF THE INVENTION

The present disclosure relates to a luminescent compound, a method of manufacturing the same, and a light-emitting device including the same.

### BACKGROUND OF THE INVENTION

Light-emitting devices are devices having the capacity to convert electrical energy into light energy. Taewan Jun et al describe Cs₃Cu₂I₅, used as a luminescent emitter in a LED, see "Lead-Free Highly Efficient Blue-Emitting Cs3Cu2I5 with 0D Electronic Structure", Advanced Materials, vol. 30, no. 43, 14 September 2018 (2018-09-14), page 1804547.

According to an example, a light-emitting device includes an anode, a cathode, and an emission layer interposed between the anode and the cathode. In addition, a hole transport region may be disposed between the anode and the emission layer, and an electron transport region may be disposed between the emission layer and the cathode. Holes provided from the anode may move toward the emission layer through the hole transport region, and electrons provided from the cathode may move toward the emission layer through the electron transport region. The holes and electrons recombine in the emission layer to produce excitons. These excitons change from an excited state to the ground state to thereby generate light.

### SUMMARY OF THE INVENTION

Provided are a novel luminescent compound, a method of preparing the same, a light-emitting device using the same. Particularly, provided are a novel luminescent compound free of lead, a method of preparing the same, a light-emitting device using the same.

Additional aspects will be set forth in part in the description which follows and, in part, will be apparent from the description, or may be learned by practice of the presented embodiments of the disclosure.

According to an aspect, there is provided a luminescent compound represented by Formula 1:

Formula 1 [A¹ₙA²₍₃₋ₙ₎][B¹ₘB²₍₂₋ₘ₎]X₅

wherein, in Formula 1,
A¹ and A² are each independently at least one alkali metal, A¹ and A² being different from each other;
B¹ and B² are each independently, at least one element of Group 11, B¹ and B² being different from each other;
n is a real number satisfying 0 ≤ n ≤ 3;
m is a real number satisfying 0 ≤ m ≤ 2;
n and m are not zero at the same time;
3-n and 2-m are not zero at the same time; and
X is at least one halogen.

In an embodiment, A¹ may be at least one of Li, Na, K or Rb, and A² may be Cs.

In one or more embodiments, A¹ may be at least one of Li, Na or K, and A² may be Cs.

In one or more embodiments, B¹ and B² may each independently be at least one of Cu, Ag, or Au.

In one or more embodiments, B¹ may be at least one of Au or Ag, and B² may be Cu.

In one or more embodiments, n may be a real number satisfying 0 < n < 3, or m may be a real number satisfying 0 < m < 2.

In one or more embodiments, X may be iodine (I).

In one or more embodiments, the luminescent compound may be represented by a compound of Formula 1-1:

Formula 1-1 [A¹ₙCs₍₃₋ₙ₎][B¹ₘCu₍₂₋ₘ₎]X₅

wherein, in Formula 1-1,
A1 is at least one alkali metal different from Cs;
B1 is at least one element of Group 11 different from Cu;
n is a real number satisfying 0 ≤ n ≤ 3;
m is a real number satisfying 0 ≤ m ≤ 2;
n and m are not zero at the same time;
3-n and 2-m are not zero at the same time; and
X is at least one halogen.

In one or more embodiments, A¹ may be at least one of Na or K.

In one or more embodiments, n may be a real number satisfying 0 < n < 3, or m may be a real number satisfying 0 < m < 2.

In one or more embodiments, n may be a real number satisfying 0 < n < 2.

In one or more embodiments, n may be a real number satisfying 0 < n < 2, and m may be 0.

In one or more embodiments, the luminescent compound may have a maximum photoluminescence wavelength of between about 420 nanometers (nm) and about 520 nm.

In one or more embodiments, the luminescent compound may have a full width at half maximum (FWHM) of about 100 nm or less, when analyzed using photoluminescence spectroscopy.

According to an aspect, a method of manufacturing the above-described luminescent compound includes: providing, onto a substrate, a mixture including at least of an A¹-containing precursor or an A²-containing precursor, at least one of a B¹-containing precursor or a B²-containing precursor, and a solvent; performing crystallization by adding an antisolvent to the mixture on the substrate; and removing the solvent and the antisolvent from the mixture on the substrate by thermal treatment to prepare the luminescent compound represented by Formula 1,

Formula 1 [A¹ₙA²₍₃₋ₙ₎][B¹ₘB²₍₂₋ₘ₎]X₅

wherein, in Formula 1,
A¹ and A² are each independently at least one alkali metal, A¹ and A² being different from each other,
B¹ and B² are each independently, at least one element of Group 11, B¹ and B² being different from each other,
n is a real number satisfying 0 ≤ n ≤ 3,
m is a real number satisfying 0 ≤ m ≤ 2,
n and m are not zero at the same time,
3-n and 2-m are not zero at the same time, and
X is at least one halogen.

In one or more embodiments, a molar ratio of the at least one of the A¹-containing precursor or the A²-containing precursor to the at least one of the B¹-containing precursor or the B²-containing precursor may be about 3:2 to about 4.5:2.

In one or more embodiments, the solvent may be at least one of dimethyl formamide, dimethyl sulfoxide, γ-butyrolactone, or N-methyl-2-pyrrolidone, and the antisolvent may be at least one of diethyl ether, toluene, α-terpineol, hexyl carbitol, butyl carbitol acetate, hexyl cellosolve, or butyl cellosolve acetate.

According to an aspect, a light-emitting device includes: a first electrode; a second electrode opposite to the first electrode; and an emission layer interposed between the first electrode and the second electrode, wherein the emission layer includes a luminescent compound of Formula 1:

Formula 1 [A¹ₙA²₍₃₋ₙ₎][B¹ₘB²₍₂₋ₘ₎]X₅

wherein, in Formula 1,
A¹ and A² are each independently at least one alkali metal, A¹ and A² being different from each other;
B¹ and B² are each independently, at least one element of Group 11, B¹ and B² being different from each other;
n is a real number satisfying 0 ≤ n ≤ 3;
m is a real number satisfying 0 ≤ m ≤ 2;
n and m are not zero at the same time;
3-n and 2-m are not zero at the same time; and
X is at least one halogen.

In one or more embodiments, the light-emitting device may further include at least one of a hole transport region interposed between the first electrode and the emission layer, or an electron transport region interposed between the emission layer and the second electrode.

In one or more embodiments, the light-emitting device may further include a charge control layer, wherein the charge control layer is between at least one of: the first electrode and the emission layer or the emission layer and the second electrode.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic cross-sectional view, according to an embodiment, of a light-emitting device;
FIG. 2 illustrates the results of X-ray photoelectron spectroscopy (XPS) of Compounds 1, 2, 5, and A;
FIG. 3 illustrates the results of X-ray diffractometry (XRD) of Compounds 2, 5, and A;
FIG. 4A is a scanning electron microscope (SEM) image of Compound 2; FIG. 4B is a SEM image of Compound 5; FIG. 4C is a SEM image of Compound A;
FIG. 5 illustrates room-temperature photoluminescence (PL) spectra of Compounds 2, 5, 8, and A;
FIG. 6 illustrates room-temperature PL spectra of Compounds 10, 11, and A;
FIG. 7 illustrates the photoluminescence quantum yield (PLQY) analysis results of Compounds 1 to 9 and A.

### DETAILED DESCRIPTION OF THE EMBODIMENTS

Reference will now be made in detail to embodiments, examples of which are illustrated in the accompanying drawings. Effects, features, and a method of achieving the present disclosure will be obvious by referring to example embodiments of the present disclosure with reference to the attached drawings. The present disclosure may, however, be embodied in many different forms and should not be construed as being limited to the embodiments set forth herein.

General and widely used terms have been employed herein, in consideration of functions provided in the present disclosure, and may vary according to an intention of one of ordinary skill in the art, a precedent, or emergence of new technologies. Additionally, in some cases, an applicant may arbitrarily select specific terms. Then, the applicant will provide the meaning of the terms in the description of the present disclosure. Accordingly, it will be understood that the terms used herein should be interpreted as having a meaning that is consistent with their meaning in the context of the relevant art and will not be interpreted in an idealized or overly formal sense unless expressly so defined herein.

As used herein, the terms such as "including," "having," or the like are intended to indicate the existence of the features or elements disclosed in the specification, and are not intended to preclude the possibility that one or more other features or elements may exist or may be added.

In the accompanying drawings, like reference numerals refer to like elements throughout and the sizes of elements are exaggerated or reduced for clarity and ease of description.

It will also be understood that when an element such as a layer, a film, a region or a component is referred to as being "on" another layer or element, it can be directly on the other layer or element, or intervening layers, regions, or components may also be present. When an element is referred to as being "directly on" or "immediately on," this means that an intervening element is not present.

As used herein, the singular forms "a," "an," and "the" are intended to include the plural forms as well, unless the context clearly indicates otherwise.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

As used herein, the term "Group" refers to a group of the IUPAC periodic table of elements.

As used herein, the term "alkali metal" refers to an element of Group 1.

As used herein, the term "halogen" refers to an element of Group 17.

As used herein, the term "maximum photoluminescence wavelength" refers to the wavelength at the maximum photoluminescence intensity in the photoluminescence (PL) spectrum of a sample prepared as a solution or film including a compound.

As used herein, the term "full width at half maximum" (FWHM) refers to the wavelength width at half (1/2) of the maximum photoluminescence intensity in the PL spectrum.

Hereinafter, embodiments of a luminescent compound, a method of manufacturing the same, and a light-emitting device including the same will be described in detail with reference to the appended drawings.

### Luminescent compound

According to an embodiment, there is provided a luminescent compound represented by Formula 1:

Formula 1 [A¹ₙA²₍₃₋ₙ₎][B¹ₘB²₍₂₋ₘ₎]X₅

In Formula 1, A¹ and A² may each independently be at least one alkali metal, and A¹ and A² may be different from each other.

In one or more embodiments, in Formula 1, A¹ may be at least one of Li, Na, K, or Rb, and A² may be Cs. For example, in Formula 1, A¹ may be at least one of Li, Na, or K, and A² may be Cs. In one or more embodiments, in Formula 1, A¹ may be at least one of Na or K, and A² may be Cs.

In Formula 1, B¹ and B² may each dependently be at least one element of Group 11, and B¹ and B² may be different from each other.

In one or more embodiments, in Formula 1, B¹ and B² may each independently be at least one of Cu, Ag, or Au. For example, in Formula 1, B¹ may be at least one of Au or Ag, and B² may be Cu.

In Formula 1, n may be a real number satisfying 0 ≤ n ≤ 3.

In Formula 1, m may be a real number satisfying 0 ≤ m ≤ 2.

In Formula 1, n and m may not be 0 at the same time.

In Formula 1, 3-n and 2-m may not be 0 at the same time.

In one or more embodiments, in Formula 1, n may be a real number satisfying 0 < n < 3, or m may be a real number satisfying 0 < m < 2. For example, in Formula 1, n may be a real number satisfying 0 < n < 3, and m may be a real number satisfying 0 < m < 2.

In Formula 1, X may be at least one halogen.

In one or more embodiments, in Formula 1, X may be selected from Cl, Br, and I. For example, in Formula 1, X may be I.

In one or more embodiments, the luminescent compound may be represented by a compound of Formula 1-1. However, embodiments are not limited thereto.

Formula 1-1 [A¹ₙCs₍₃₋ₙ₎][B¹ₘCu₍₂₋ₘ₎]X₅

In Formula 1-1,
A1 is at least one alkali metal different from Cs;
B1 is at least one element of Group 11 different from Cu;
n is a real number satisfying 0 ≤ n ≤ 3;
m is a real number satisfying 0 ≤ m ≤ 2;
n and m are not zero at the same time;
3-n and 2-m are not zero at the same time; and
X is at least one halogen.

For example, in Formula 1-1, A¹ may be at least one of Li, Na, K, or Rb. In one or more embodiments, in Formula 1-1, A¹ may be at least one of Li, Na, or K. In one or more embodiments, in Formula 1-1, A¹ may be at least one of Na or K.

For example, in Formula 1-1, B¹ may be at least one of Au or Ag.

For example, in Formula 1-1, n may be a real number satisfying 0 < n < 3, or m may be a real number satisfying 0 < m < 2. In one or more embodiments, in Formula 1-1, n may be a real number satisfying 0 < n < 3, and m may be a real number satisfying 0 < m < 2. In one or more embodiments, in Formula 1-1, n may be a real number satisfying 0 < n < 2. In one or more embodiments, in Formula 1-1, n may be a real number satisfying 0 < n < 2, and m may be 0.

For example, in Formula 1-1, X may be at least one of Cl, Br, or I. In one or more embodiments, in Formula 1-1, X may be I.

In one or more embodiments the luminescent compound may be represented by a compound of Formula 1-2. However, embodiments are not limited thereto:

Formula 1-2 [A¹ₙCs₍₃₋ₙ₎][B¹ₘCu₍₂₋ₘ₎]I₅

wherein, in Formula 1-2,
A¹ is at least one alkali metal different from Cs;
B¹ is at least one element of Group 11 different from Cu;
n is a real number satisfying 0 ≤ n ≤ 3;
m is a real number satisfying 0 ≤ m ≤ 2;
n and m are not zero at the same time; and
3-n and 2-m are not zero at the same time.

For example, in Formula 1-2, A¹ may be at least one of Li, Na, K, or Rb. In one or more embodiments, in Formula 1-2, A¹ may be at least one of Li, Na, or K. In one or more embodiments, in Formula 1-2, A¹ may be at least one of Na or K.

For example, in Formula 1-2, B¹ may be at least one of Au or Ag.

For example, in Formula 1-2, n may be a real number satisfying 0 < n < 3, or m may be a real number satisfying 0 < m < 2. In one or more embodiments, in Formula 1-1, n may be a real number satisfying 0 < n < 3, and m may be a real number satisfying 0 < m < 2. In one or more embodiments, in Formula 1-2, n may be a real number satisfying 0 < n < 2. In one or more embodiments, in Formula 1-2, n may be a real number satisfying 0 < n < 2, and m may be 0.

In one or more embodiments, the luminescent compound may be at least one of Na_{0.5}Cs_{2.5}Cu₂I₅, NaCs₂Cu₂I₅, Na₂CsCu₂I₅, K_{0.5}Cs_{2.5}Cu₂I₅, KCs₂Cu₂I₅, K₂CsCu₂I₅, Rb_{0.5}Cs_{2.5}Cu₂I₅, RbCs₂Cu₂I₅, Rb₂CsCu₂I₅, Cs₃Au_{0.1}Cu_{1.9}I₅, or Cs₃Ag_{0.1}Cu_{1.9}I₅. However, embodiments are not limited thereto.

The luminescent compound may emit blue light.

The luminescent compound may have a maximum photoluminescence wavelength (measured value) of about 420 nm or greater and about 520 nm or smaller. The luminescent compound may have a maximum photoluminescence wavelength (measured value) of, for example, about 420 nm or greater, about 430 nm or greater, about 495 nm or smaller, about 475 nm or smaller, or about 450 nm or smaller. In particular, when the luminescent compound has a maximum photoluminescence wavelength of about 420 nm to about 475 nm, a light-emitting device having a deep blue emission color may be provided.

The luminescent compound may have a full width at half maximum (FWHM) of about 100 nm or less. In particular, the luminescent compound may have a FWHM of about 90 nm or less, 85 nm or less, 80 nm or less, 75 nm or less, 70 nm or less, 50 nm or less, 30 nm or less, or 20 nm or less. In the luminescent compound represented by Formula 1, unlike Cs₃Cu₂I₅, the lattice positions of Cs may be partially substituted with a different alkali metal atom, or the lattice positions of Cu may be partially substituted with another Group 11 element. Accordingly, the luminescent compound represented by Formula 1 may have orbital asymmetry, thus leading to an increased photoluminescence quantum yield (PLQY).

When the luminescent compound represented by Formula 1 includes K or Na, such orbital asymmetry may be greater as compared with when the luminescent compound includes Rb, resulting in a higher PLQY.

The luminescent compound represented by Formula 1 may have relatively high stability. For example, the luminescent compound may have an exciton binding energy greater than about 0.5 eV.

Commercially available examples of inorganic compounds or organic-inorganic complex compounds that exhibit acceptable performance in terms of emission characteristics and/or stability include elements such as cadmium and lead, which cause environmental problems. However, the luminescent compound represented by Formula 1 may achieve emission characteristics and/or stability comparable to commercially available compounds without including elements such as cadmium and lead, and thus will not cause environmental problems.

A person of ordinary skill in the art would understand a method of preparing the luminescent compound represented by Formula 1 with reference to the following preparation methods and synthesis examples described below.

### Method of preparing luminescent compound

According to an embodiment, there is provided a method of manufacturing a luminescent compound represented by Formula 1, the method comprising: providing, onto a substrate, a mixture including at least one selected from an A¹-containing precursor and an A²-containing precursor, at least one selected from a B¹-containing precursor and a B²-containing precursor, and a solvent; performing crystallization by adding an antisolvent; and removing the solvent and the antisolvent by thermal treatment.

First, a mixture including at least one of an A¹-containing precursor or an A²-containing precursor, at least one of a B¹-containing precursor or a B²-containing precursor, and a solvent may be provided onto a substrate.

In the mixture, a molar ratio of the at least one of the A¹-containing precursor or the A²-containing precursor, and the at least one of the B¹-containing precursor or the B²-containing precursor may be determined according to the composition of a finally produced luminescent compound represented by Formula 1.

In particular, in the finally produced luminescent compound represented by Formula 1, a ratio of the sum of atomic ratios of A¹ and A² to the sum of atomic ratios of B¹ and B² may be about 3: 2. Accordingly, the composition of the mixture may be in this range. In particular, a molar ratio of the at least one of the A¹-containing precursor or the A²-containing precursor to the at least one of the B¹-containing precursor or the B²-containing precursor may be about 3:2 to about 4.5:2. However, embodiments are not limited thereto.

For example, the mixture may be spin-coated on the substrate. When the mixture is provided by spin coating, the spin coating conditions may be selected within, for example, the range of a coating speed of about 300 rpm to about 4000 rpm and the range of temperatures of about 80 °C to about 200 °C, depending on the composition of the mixture. In particular, the coating speed may be controlled according to intervals. For example, the coating speed may be maintained at about 300 rpm to about 700 rpm in a first interval, and at about 2000 rpm to about 4000 rpm in a second interval.

The mixture may be provided on the substrate by using any suitable method.

The solvent may be a material in which an A¹-containing precursor, an A²-containing precursor, a B¹-containing precursor, or a B²-containing precursor have high solubility. For example, the solvent may be at least one of dimethyl formamide, dimethyl sulfoxide, γ-butyrolactone, or N-methyl-2-pyrrolidone. However, embodiments are not limited thereto.

Next, crystallization may be performed by adding an antisolvent onto the substrate to which the mixture has been provided.

For example, when the mixture is provided by spin coating, after the mixture is spin-coated, the antisolvent may be added as a dropwise addition or by spraying, while the substrate is continuously rotated.

The antisolvent may be a material in which an A¹-containing precursor, an A²-containing precursor, a B¹-containing precursor, or a B²-containing precursor has low solubility. For example, the antisolvent may be at least one of diethyl ether, toluene, α-terpineol, hexyl carbitol, butyl carbitol acetate, hexyl cellosolve, or butyl cellosolve acetate. However, embodiments are not limited thereto. For example, the antisolvent may be diethyl ether.

Next, the solvent and the antisolvent may be removed from the mixture on the substrate by thermal treatment.

For example, the thermal treatment conditions may be selected within, for example, a range of time of about 15 minutes to about 2 hours, about 30 minutes to about 1.5 hours, or about 1 hour, and a range of temperatures of about 50 °C to about 200 °C, about 75 °C to about 175 °C, about 100 °C to about 150 °C, or about 125 °C, in depending on the composition of the mixture.

In regard to the A¹-containing precursor, the A²-containing precursor, the B¹-containing precursor, and the B²-containing precursor, A¹, A², B¹, and B² may be defined as described in connection with Formula 1.

For example, the A¹-containing precursor may be at least one halide of A¹ (for example, A¹X), the A²-containing precursor may be at least one halide of A² (for example, A²X), the B¹-containing precursor may be at least one halide of B¹ (for example, B¹X), the B²-containing precursor may be at least one halide of B² (for example, B²X). In the formula of A¹X¹, A²X, B¹X, and B²X, A¹, A², B¹, B² and X may be defined as described in connection with Formula 1.

### Light-emitting device

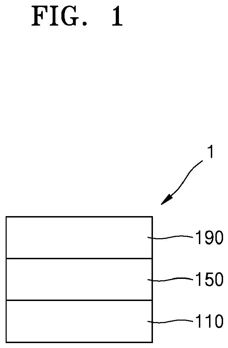

According to an embodiment, as illustrated in FIG. 1, a light-emitting device 1 may include: a first electrode 110; a second electrode 190 opposite to the first electrode 110; and an emission layer 150 interposed between the first electrode 110 and the second electrode 190, the emission layer 150 containing the above-described luminescent compound.

A structure of the light-emitting device 1 will be described with reference to FIG. 1. FIG. 1 is a schematic cross-sectional view of the light-emitting device 1 according to an embodiment.

Although not shown in FIG. 1, a substrate may be further arranged under the first electrode 110 (i.e., in the direction opposite to the emission layer 150) and/or on top of the second electrode 190) (i.e., in the direction opposite to the emission layer 150). The substrate may be a substrate suitable for use in light-emitting devices. The substrate may be a glass substrate or a transparent plastic substrate having excellent mechanical strength, thermal stability, transparency, surface smoothness, ease of handling, and water resistance.

The first electrode 110 may be an anode to which a positive (+) voltage is applied, and the second electrode 190 may be a cathode to which a negative (-) voltage is applied, or the first electrode 110 may be a cathode, and the second electrode 190 may be an anode. As a matter of convenience, embodiments will be described with the assumption that the first electrode 110 is an anode, and the second electrode 190 is a cathode.

The first electrode 110 may be formed, for example, by depositing or sputtering, onto the substrate, a material for the first electrode. The first electrode 110 may be a reflective electrode, a semi-transmissive electrode, or a transmissive electrode. For example, to obtain a rear-emission light-emitting device, the first electrode 110 may be a semi-transmissive electrode or a transmissive electrode. To obtain a front-emission light-emitting device, the first electrode 110 may be a reflective electrode. Other various modifications may be possible. The first electrode 110 may have a single-layered structure, or a multi-layered structure including two or more layers.

The first electrode 110 may include a material having a high work function to facilitate injection of holes. For example, a material for the first electrode may include at least one of indium tin oxide (ITO), indium zinc oxide (IZO), indium oxide, tin oxide (SnO₂), zinc oxide (ZnO), or gallium oxide. In one embodiment, a material for the first electrode may include at least one of magnesium (Mg), aluminum (Al), aluminum-lithium (Al-Li), calcium (Ca), magnesium-indium (Mg-In), or magnesium-silver (Mg-Ag).

The second electrode 190 may be provided so as to be opposite to the first electrode 110. The second electrode 190 may be a reflective electrode, a semi-transmissive electrode, or a transmissive electrode. For example, to obtain a rear-emission light-emitting device, the second electrode 190 may be a reflective electrode. To obtain a front-emission light-emitting device, the second electrode 190 may be a semi-transmissive electrode or a transmissive electrode. Other various modifications may be possible. The second electrode 190 may have a single-layered structure, or a multi-layered structure including two or more layers.

The second electrode 190 may include at least one of a metal having a relatively low work function, an alloy thereof, or an electrically conductive compound. For example, a material for the second electrode may include at least one of lithium (Li), magnesium (Mg), aluminum (Al), aluminum-lithium (Al-Li), calcium (Ca), gallium (Ga), magnesium-indium (Mg-In), or magnesium-silver (Mg-Ag). In other embodiments, a material for the second electrode may include at least one of ITO or IZO.

The emission layer 150 may include the luminescent compound represented by Formula 1. In the emission layer 150, electrons and holes transferred due to voltages applied to the first electrode 110 and the second electrode 190 may combine. After being generated by the combination of electrons and holes, excitons may emit light while transitioning from an excited state to a ground state. The light-emitting device including the luminescent compound represented by Formula 1 may have high color purity, high current efficiency, or high quantum efficiency.

The detailed description of the luminescent compound represented by Formula 1 may be referred to herein.

The luminescent compound may be present in the emission layer at a uniform concentration or with a certain concentration gradient.

When the light-emitting device is a full-color light-emitting device, it may include emission layers that emit different colors of light for respective individual sub-pixels.

For example, the emission layer may be patterned into a first-color emission layer, a second-color emission layer, and a third-color emission layer for individual sub-pixels, respectively. At least one emission layer among these emission layers may include the luminescent compound represented by Formula 1. For example, the first-color emission layer may be an emission layer including the luminescent compound represented by Formula 1, and the second-color emission layer and the third-color emission layer may be organic emission layers including different organic compounds, respectively. Each emission layer may emit a different color. For example, the first-color emission layer, the second-color emission layer, and the third color emission layer may each have different maximum photoluminescence wavelengths. The first, the second, and the third colors may become white when combined with each other.

In one or more embodiments, the emission layer may further include a fourth-color emission layer. At least one emission layer of the first-color emission layer to the fourth-color emission layer may be an emission layer including the luminescent compound represented by Formula 1, and the remaining emission layers may be organic emission layers, including different organic compounds, respectively. Other modifications may be possible. Each of the first to fourth colors may be different colors. For example, the first - color emission layer, the second-color emission layer, the third-color emission layer, and the fourth-color emission layer may each have different maximum photoluminescence wavelengths. The first, the second, the third, and the fourth colors may become white when combined with each other.

In one or more embodiments, the light-emitting device may have a structure in which two or more emission layers which emit different colors are stacked in contact with each other or stacked separately from each other. At least one emission layer of the two or more emission layers may be an emission layer including the luminescent compound, and the remaining emission layers may be organic emission layers including different organic compounds, respectively. Other modifications may be possible.

The emission layer 150 may further include, in addition to the luminescent compound represented by Formula 1, at least one of an organic compound, an inorganic compound different from Formula 1, an organic-inorganic composite compound, or quantum dots. However, embodiments are not limited thereto.

The emission layer 150 may have a thickness of about 10 nm to about 200 nm, for example, about 50 nm to about 100 nm. When the thickness of the emission layer 150 is within these ranges, the emission layer 150 may exhibit excellent emission characteristics, without a substantial increase in driving voltage.

An additional layer for adjusting the charge carrier balance in the device may be further included between the first electrode 110 and the emission layer 150 and/or between the second electrode 190 and the emission layer 150, in order to improve device characteristics such as emission efficiency. For example, the light-emitting device may further include a hole transport region between the first electrode 110 and the emission layer 150, or an electron transport region between the second electrode 190 and the emission layer 150.

The hole transport region may inject and/or transport holes from the first electrode 110 to the emission layer 150. In addition, the hole transport region may increase efficiency by compensating for an optical resonance distance, which is dependent on the wavelength of light emitted from the emission layer 150.

The hole transport region may include at least one of a hole injection layer, a hole transport layer, or a charge control layer. The hole transport region may have a single-layer structure or a multi-layer structure, including two or more layers. For example, the hole transport region may include only a hole injection layer or a hole transport layer. In some embodiments, the hole transport region may have a stacked structure including a hole injection layer/hole transport layer or a hole injection layer/hole transport layer/charge control layer, these layers being sequentially stacked on the first electrode 110.

The hole transport region may include, for example, at least one of mCP (1 ,3-bis(9-carbazolyl)benzene), CBP (4,4'-bis(N-carbazolyl)-1,1'-biphenyl), mCBP (3,3-bis(carbazol-9-yl)bipheny), m-MTDATA (4,4',4"-tris[phenyl(m-tolyl)amino]triphenylamine), TDATA, 2-TNATA, NPB (N,N'-di(1-naphthyl)-N,N'-diphenyl-(1,1'-biphenyl)-4,4'-diamine), β-NPB, TPD (N,N'-bis(3-methylphenyl)-N,N'-diphenylbenzidine), Spiro-TPD, Spiro-NPB, methylated-NPB, TAPC, HMTPD, TCTA (tris(4-carbazoyl-9-ylphenyl)amine), Pani/DBSA (polyaniline/dodecylbenzenesulfonic acid), PEDOT/PSS (poly(3,4-ethylenedioxythiophene)/poly(4-styrenesulfonate), TFB (poly(9,9-dioctyl-fluorene-co-N-(4-butylphenyl)-diphenylamine)), polyarylamine, PVK (poly(N-vinylcarbazole)), polypyrrole, Pani/CSA (polyaniline/camphor sulfonic acid), or PANI/PSS (polyaniline)/poly(4-styrenesulfonate)). However, embodiments are not limited thereto.

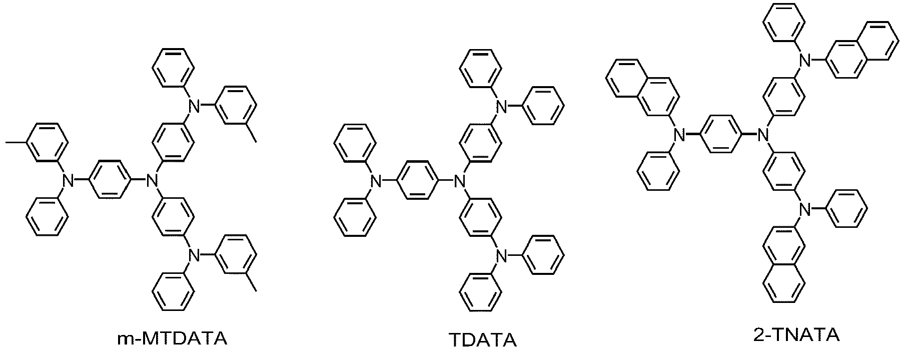

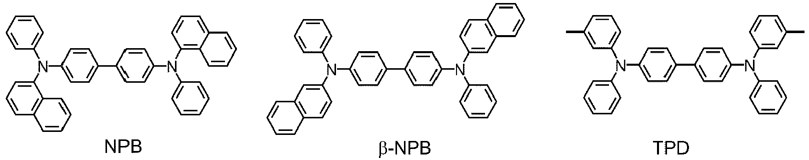

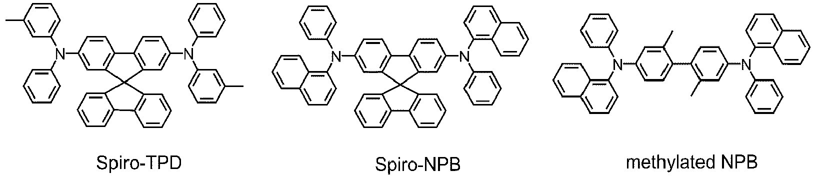

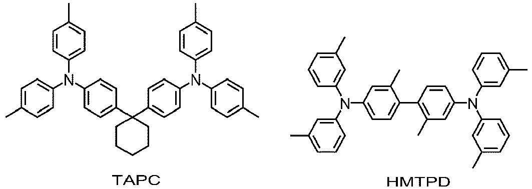

The thickness of the hole transport region may be determined based on the wavelength of light emitted from the emission layer, the driving voltage, and the current efficiency of the light-emitting device, or the like. For example, the hole transport region may have a thickness of about 10 nm to about 1000 nm, for example, about 10 nm to about 100 nm. When the hole transport region includes both a hole injection layer and a hole transport layer, the hole injection layer may have a thickness of about 10 nm to about 200 nm, about 25 nm to about 175 nm, about 50 nm to about 150 nm, or about 75 nm to about 125 nm and the hole transport layer may have a thickness of about 5 nm to about 100 nm, about 10 nm to about 90 nm, about 20 nm to about 80 nm, or about 40 nm to about 60 nm.

The hole transport region may further include a p-dopant, in addition to the above-described materials, to improve conductivity. The p-dopant may be uniformly or nonuniformly dispersed in the hole transport region.

The p-dopant may be at least one of a quinone derivative, a metal oxide, or a cyano group-containing compound. However, embodiments are not limited thereto. Nonlimiting examples of the p-dopant are quinine derivatives such as tetracyanoquinonedimethane (TCNQ) or 2,3,5,6-tetrafluoro-tetracyano-1,4-benzoquinonedimethane (F4-TCNQ); metal oxides such as tungsten oxide or molybdenum oxide; or cyano group-containing compounds such as dipyrazino[2,3-f:2',3'-h]quinoxaline-2,3,6,7,10,11-hexacarbonitrile (HAT-CN). However, embodiments are not limited thereto.

The electron transport region may inject and/or transport electrons from the second electrode 190 to the emission layer 150. In addition, the electron transport region may increase efficiency by compensating for an optical resonance distance according to a wavelength of light emitted from the emission layer.

The electron transport region may include at least one of an electron injection layer, an electron transport layer, or a charge control layer. The electron transport region may have a single-layer structure or a multi-layer structure, including two or more layers. For example, the electron transport region may include only an electron injection layer or only an electron transport layer. In some embodiments, the hole transport region may have a stacked structure of an electron transport layer/electron injection layer or a stacked structure of a charge control layer/electron transport layer/electron injection layer, these layers being sequentially stacked on the emission layer 150.

For example, the electron transport region may include at least one of Alq₃, BCP (Bathocuproine), Bphen (4,7-diphenyl-1,10-phenanthroline), Balq (bis(2-methyl-8-quinolinolato-N1,O8)-(1,1'-biphenyl-4-olato)aluminum), TAZ (3-(Biphenyl-4-yl)-5-(4-tert-butylphenyl)-4-phenyl-4H-1,2,4-triazole), NTAZ (4-(naphthalen-1-yl)-3,5-diphenyl-4H-1,2,4-triazole) Bebq₂ (bis(10-hydroxybenzo[h]quinolinato)beryllium), B3PYMPM, TPBI, 3TPYMB, BmPyPB, TmPyPB, BSFM, PO-T2T, or PO15. However, embodiments are not limited thereto. For example, the electron transport layer and/or the charge control layer may include at least one of the above-listed compounds. However, embodiments are not limited thereto.

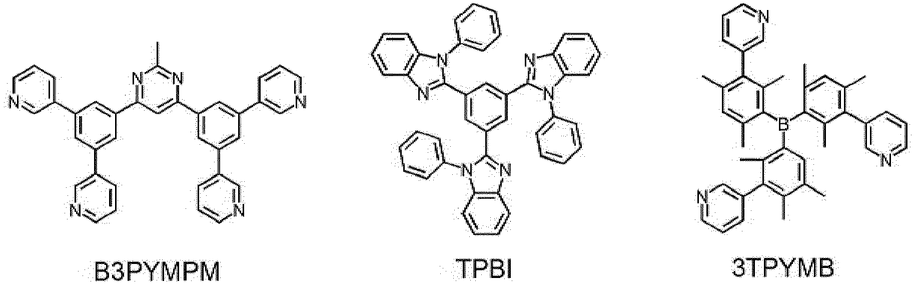

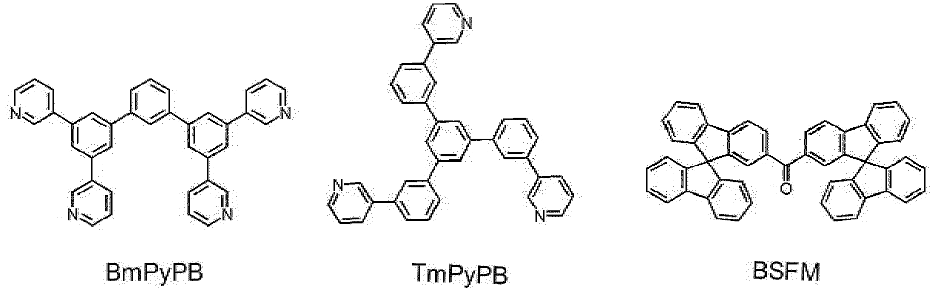

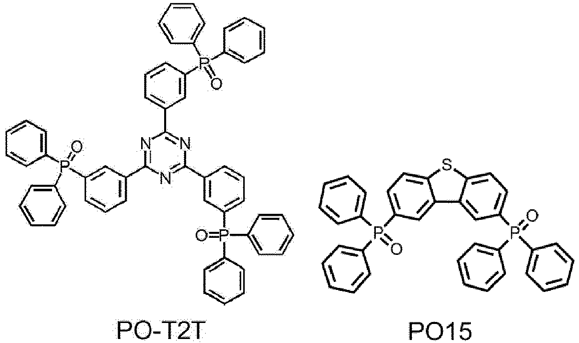

For example, the electron injection layer may include at least one of an alkali metal, an alkaline earth metal, a rare earth metal, a compound comprising an alkali metal, a compound comprising an alkaline earth metal, a compound comprising a rare earth metal, an alkali metal complex, an alkaline earth metal complex, or a rare earth metal complex. The electron injection layer may further include an organic compound as listed above. However, embodiments are not limited thereto.

In one or more embodiments, the electron injection layer may include at least one of LiF, NaF, CsF, KF, Li₂O, Cs₂O, K₂O, BaO, SrO, CaO, or 8-quinolinolato lithium (LiQ). The electron injection layer may further include an organic compound as listed above. However, embodiments are not limited thereto.

The thickness of the electron transport region may be determined based on the wavelength of light emitted from the emission layer, the driving voltage, and the current efficiency of the light-emitting device, or the like. For example, the electron transport region may have a thickness of about 1 nm to about 1000 nm, for example, about 1 nm to about 200 nm. When the electron transport region includes both an electron injection layer and an electron transport layer, the electron injection layer may have a thickness of about 1 nm to about 50 nm, and the electron transport layer may have a thickness of about 5 nm to about 100 nm.

The charge control layer may be included to control charge-injection balance in the interface between an organic compound-containing layer (for example, the hole transport layer, the electron transport layer, or the like) and an inorganic compound-containing layer (for example, the emission layer). The charge control layer may include, for example, at least one of a polymer compound such as PMMA (poly(methyl methacrylate)), PI (polyimide), PVA (polyvinyl alcohol), a combination thereof, or a copolymer thereof. However, embodiments are not limited thereto. By the inclusion of the electron control layer, the light-emitting device may have improved charge injection balance and increased external quantum efficiency. In addition, since the electron control layer is located immediately adjacent to the emission layer, the emission layer may be planarized, and a driving voltage of the light-emitting device may be reduced.

In one or more embodiments, the light-emitting device may include a hole transport region interposed between the first electrode and the emission layer, and/or an electron transport region interposed between the emission layer and the second electrode.

In one or more embodiments, the light-emitting device may include a charge control layer between the first electrode and the emission layer and/or between the emission layer and the second electrode.

The layers of the light-emitting device 1 may be formed by using any suitable method, for example, vacuum deposition, spin coating, casting, or Langmuir-Blodgett (LB) deposition.

When the hole injection layer is formed by using vacuum deposition, the vacuum deposition conditions may vary depending on the material of the hole injection layer, and the desired structure and thermal properties of the hole injection layer to be formed. For example, the deposition temperature may be in the range of about 100 °C to about 500 °C, about 150 °C to about 450 °C, or about 200 °C to about 400 °C, the vacuum level may be selected from the range of about 10⁻⁸ torr to about 10⁻³ torr, about 10⁻⁷ torr to about 10⁻⁴ torr, or about 10⁻⁶ torr to about 10⁻⁵ torr, and the deposition rate may be in the range of about 0.01 nm/sec to about 100 nm/sec. However, embodiments are not limited thereto.

When the hole injection layer is formed by using spin coating, the coating conditions may vary depending on the material of the hole injection layer, and the desired structure and thermal properties of the hole injection layer to be formed. For example, the coating rate may be in the range of about 2000 rpm to about 5000 rpm, about 2500 rpm to about 4500 rpm, or about 3000 rpm to about 4000 rpm, and the temperature of thermal treatment performed to remove a solvent after coating may be selected from the range of about 80 °C to about 200 °C, about 100 °C to about 180 °C, about 120 °C to about 160 °C. However, embodiments are not limited thereto.

The light-emitting device, according to embodiments, has been described with reference to FIG. 1, but is not limited thereto.

One or more embodiments of the present disclosure will now be described in detail with reference to the following synthesis examples and other examples of the luminescent compound, a method of preparing the luminescent compound, and a light-emitting device including the luminescent compound. However, these examples are for illustrative purposes only and are not intended to limit the scope of the present disclosure. In the following synthesis examples, the expression that "B, instead of A, was used" means that the amounts of "B" and "A" were the same in molar equivalent.

### Examples

### Analysis methods

### PL spectroscopy

A luminescent compound was applied to a glass substrate to form a film having a thickness of about 200 nm to about 400 nm. The film was then excited under a nitrogen atmosphere using excitation light having a wavelength of about 290 nm to about 300 nm, and a photoluminescence (PL) spectrum of the film was measured at room temperature using an ISC PC1 spectrofluorometer.

### PLQY measurement

A luminescent compound was applied to a glass substrate to form a film having a thickness of about 200 nm to about 400 nm. The film was then excited under nitrogen atmosphere using excitation light having a wavelength of about 290 nm to about 300 nm, and a photoluminescence quantum yield (PLQY) of the film was measured using a C9920-02 and PMA-11 (available from Hamamatsu Photonics).

### XPS analysis

Atomic composition analysis was performed by X-ray photoelectron spectroscopy (XPS) using a Quantum 2000 (available from Physical Electronics) under the following conditions: an accelerating voltage of 0.5 keV to 15 keV, 300 W, a minimum analysis area of 200 µm × 200 µm, and a sputter rate of 0.1 nm/min.

### XRD analysis

Samples were analyzed using an X-ray diffractometer (XRD, Philips X'pert) equipped with a Cu target at a scanning rate of 4 °2Θ/min and an angle of 20 °2Θ to 80 °2Θ.

### Synthesis Example: Preparation of luminescent compound represented by Formula 1

Mixtures 1 to 11, and A (each including, as shown in Table 1, at least one of an A¹-containing precursor or an A²-containing precursor, at least one of a B¹-containing precursor or a B²-containing precursor, and a solvent in a predetermined molar ratio) were each spin-coated on a glass substrate, respectively, at about 500 rpm for about 30 seconds, and subsequently at about 2000 rpm to 4000 rpm for about 30 seconds. At the time of 50 seconds from the beginning of the spin coating, diethyl ether was dropwise added at a rate of 2 mL per second for about 0.5 seconds. The resulting products were thermally treated at about 60 °C to about 120 °C for about 10 minutes, thereby manufacturing the glass substrates coated with Luminescent Compounds 1 to 11 and Comparative Compound A (each having a final composition as shown in Table 2), respectively, with a thickness of about 200 nm to about 400 nm.

**Table 1**

| Mixture No. | A¹-containing precursor | A²-containing precursor | B¹-containing precursor | B²-containing precursor | Solvent | Molar ratio (A¹-containing precursor: A²-containing precursor: B¹-containing precursor: B²-containing precursor) | Precursor concentration (mole concentration) |
|---|---|---|---|---|---|---|---|
| Mixture 1 | NaI | CsI | - | CuI | DMSO | 0.5:2.5:0:2 | 2.5 |
| Mixture 2 | NaI | CsI | - | CuI | DMSO | 1 :2:0:2 | 2.5 |
| Mixture 3 | NaI | CsI | - | CuI | DMSO | 2:1:0:2 | 2.5 |
| Mixture 4 | KI | CsI | - | CuI | DMSO | 0.5:2.5:0:2 | 2.5 |
| Mixture 5 | KI | CsI | - | CuI | DMSO | 1 :2:0:2 | 2.5 |
| Mixture 6 | KI | CsI | - | CuI | DMSO | 2:1:0:2 | 2.5 |
| Mixture 7 | RbI | CsI | - | CuI | DMSO | 0.5:2.5:0:2 | 2.5 |
| Mixture 8 | RbI | CsI | - | CuI | DMSO | 1 :2:0:2 | 2.5 |
| Mixture 9 | RbI | CsI | - | CuI | DMSO | 2:1:0:2 | 2.5 |
| Mixture 10 | - | CsI | AuI | CuI | DMSO | 0:3:0.1:1.9 | 2.5 |
| Mixture 11 | - | CsI | AgI | CuI | DMSO | 0:3:0.1:1.9 | 2.5 |
| Mixture A | - | CsI | - | CuI | DMSO | 0:3:0:2 | 2.5 |

**Table 2**

| Mixture No. | Final product | Composition of final product |
|---|---|---|
| Mixture 1 | Compound 1 | Na_{0.5}Cs_{2.5}Cu₂I₅ |
| Mixture 2 | Compound 2 | NaCs₂Cu₂I₅ |
| Mixture 3 | Compound 3 | Na₂CsCu₂I₅ |
| Mixture 4 | Compound 4 | K_{0.5}Cs_{2.5}Cu₂I₅ |
| Mixture 5 | Compound 5 | KCs₂Cu₂I₅ |
| Mixture 6 | Compound 6 | K₂C_{S}Cu₂I₅ |
| Mixture 7 | Compound 7 | Rb_{0.5}Cs_{2.5}Cu₂I₅ |
| Mixture 8 | Compound 8 | RbCs₂Cu₂I₅ |
| Mixture 9 | Compound 9 | Rb₂CsCu₂I₅ |
| Mixture 10 | Compound 10 | Cs₃Au_{0.1}Cu_{1.9}I₅ |
| Mixture 11 | Compound 11 | Cs₃Ag_{0.1}Cu_{1.9}I₅ |
| Mixture A | Comparative Compound A | CS₃Cu₂I₅ |

### Experimental Example 1: XPS analysis

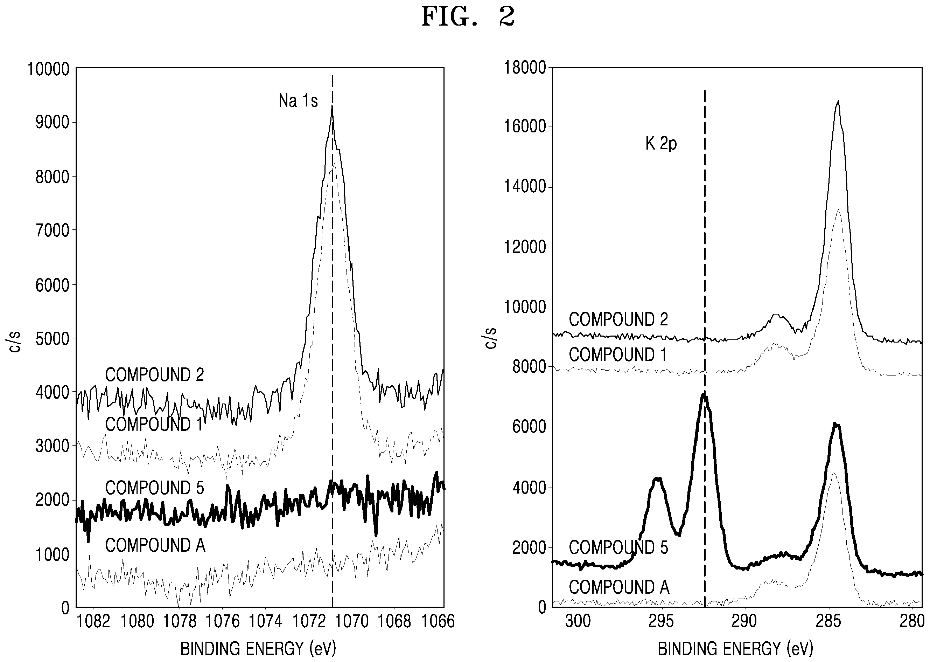

Compounds 1, 2, and 5 and Comparative Compound A were analyzed by XPS. The results are shown in Table 3 and FIG. 2.

**Table 3**

| | Na 1s intensity | K 2p intensity |
|---|---|---|
| Compound 1 | 5000 | 0 |
| Compound 2 | 5200 | 0 |
| Compound 5 | 0 | 5200 |
| Compound A | 0 | 0 |

### Experimental Example 2: XRD analysis

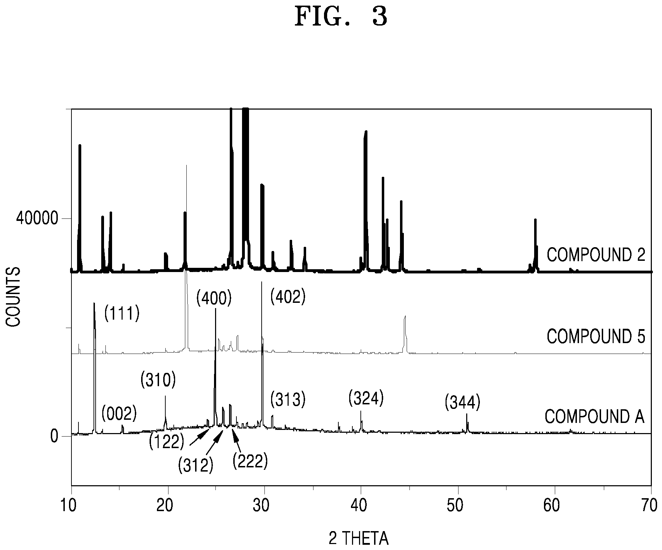

Compounds 2 and 5 and Comparative Compound A were analyzed by XRD. The results are shown in FIG. 3.
Referring to FIG. 3, compounds 2 and 5 and Comparative Compound A were found to be formed as single phase.

### Experimental Example 3: SEM observation

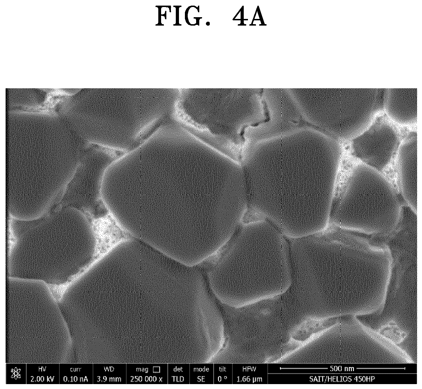

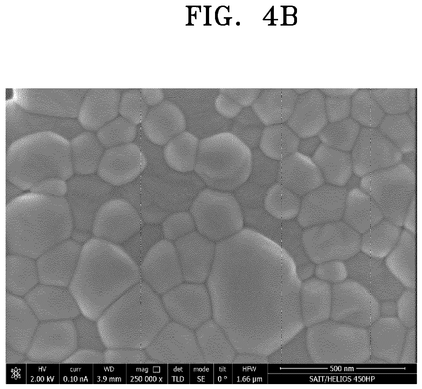

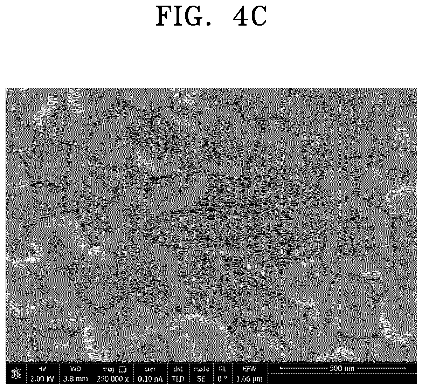

Compounds 2 and 5 and Comparative Compound A were analyzed by scanning electron microscopy (SEM). The obtained SEM images are shown in FIGs. 4A to 4C.

### Experimental Example 4: Evaluation of maximum photoluminescence wavelength (PL max) and full-width at half-maximum (FWHM)

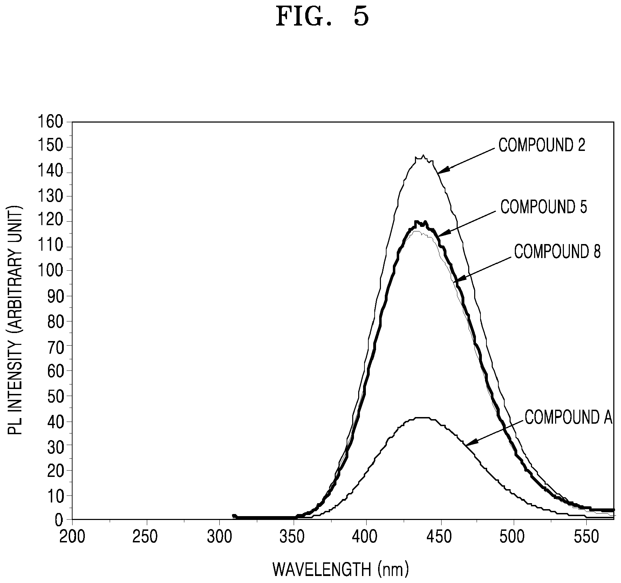

Room-temperature PL spectra of Compounds 2, 5 and 8 and Comparative Compound A were measured. The results are shown in Table 4 and FIG. 5.

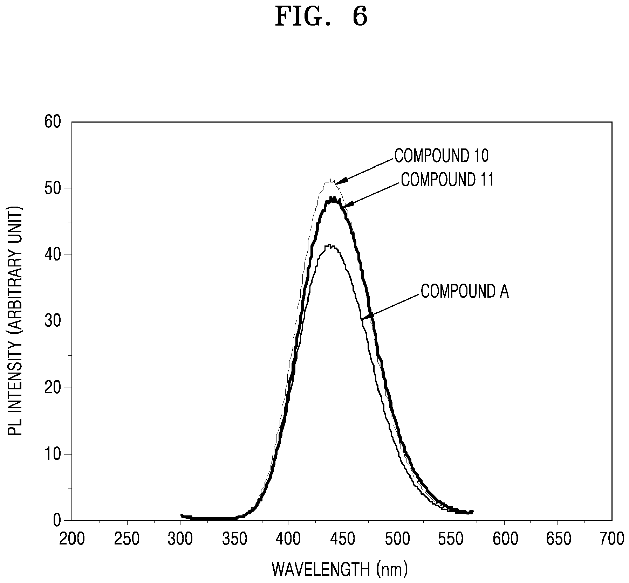

Room-temperature PL spectra of Compounds 10 and 11, and Comparative Compound A were measured. The results are shown in Table 5 and FIG. 6.

**Table 4**

| Compound No. | PL max (nm) | FWHM (nm) |
|---|---|---|
| Compound 2 | 440 | 79 |
| Compound 5 | 435 | 79 |
| Compound 8 | 434 | 81 |
| Compound A | 438 | 80 |

**Table 5**

| Compound No. | PL max (nm) | FWHM (nm) |
|---|---|---|
| Compound 10 | 438 | 79 |
| Compound 11 | 443 | 80 |
| Compound A | 438 | 80 |

Referring to Tables 4 and 5 and FIGs. 5 and 6, Compounds 2, 5, 8, 10, and 11 were found to have PL max levels similar to that of Comparative Compound A, and higher PL intensities and/or smaller FWHMs, as compared to the PL intensity and FWHM of Comparative Compound A.

### Experimental Example 5: PLQY measurement

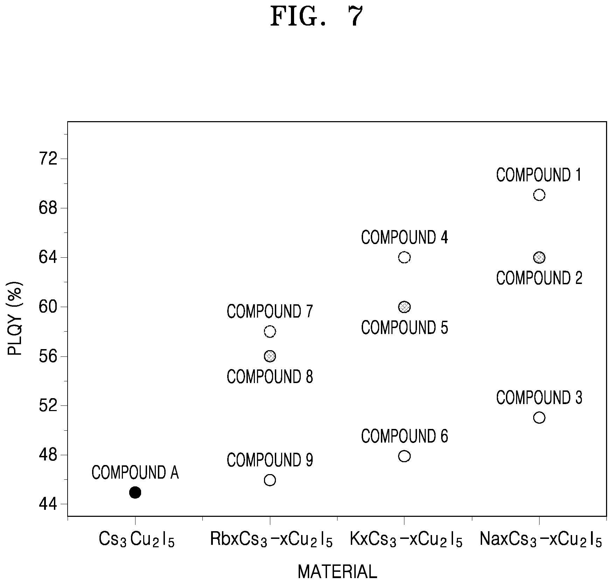

Photoluminescence quantum yields (PLQYs) of Compounds 1 to 9 and Comparative Compound A were measured. The results are shown in FIG. 7.

Referring to FIG. 7, Compounds 1 to 9 were found to have higher PLQYs than that of Comparative Compound A.

As described herein, a luminescent compound according to the one or more embodiments may have improved emission characteristics, for example, a relatively low FWHM or a relatively high emission efficiency. Thus, a light-emitting device using the luminescent compound may have improved color purity and/or efficiency.

## Claims

1. A luminescent compound represented by Formula 1:
Formula 1 [A¹ₙA²₍₃₋ₙ₎][B¹ₘB²₍₂₋ₘ₎]X₅
wherein, in Formula 1,
A¹ and A² are each independently at least one alkali metal, A¹ and A² being different from each other;
B¹ and B² are each independently at least one element of Group 11, B¹ and B² being different from each other;
n is a real number satisfying 0 ≤ n ≤ 3;
m is a real number satisfying 0 ≤ m ≤ 2;
n and m are not zero at the same time;
3-n and 2-m are not zero at the same time; and
X is at least one halogen.

2. The luminescent compound of claim 1, wherein A¹ is at least one of Li, Na, K or Rb, and A² is Cs;
preferably wherein A¹ is at least one of Li, Na or K, and A² is Cs.

3. The luminescent compound of claims 1 or 2, wherein B¹ and B² are each independently at least one of Cu, Ag, or Au;
preferably wherein B¹ is at least one of Au or Ag, and B² is Cu.

4. The luminescent compound of any of claims 1-3, wherein n is a real number satisfying 0 < n < 3, or m is a real number satisfying 0 < m < 2; and/or
wherein X is I.

5. The luminescent compound of any of claims 1-4, wherein the luminescent compound is represented by a compound of Formula 1-1:
Formula 1-1 [A¹ₙC_{S(3-n)}][B¹ₘCu₍₂₋ₘ₎]X₅
wherein in Formula 1-1,
A¹ is at least one alkali metal different from Cs;
B¹ is at least one element of Group 11 different from Cu;
n is a real number satisfying 0 ≤ n ≤ 3;
m is a real number satisfying 0 ≤ m ≤ 2;
n and m are not zero at the same time;
3-n and 2-m are not zero at the same time; and
X is at least one halogen.

6. The luminescent compound of claim 5, wherein A¹ is at least one of Na or K.

7. The luminescent compound of claims 5 or 6, wherein n is a real number satisfying 0 < n < 3, or m is a real number satisfying 0 < m < 2.

8. The luminescent compound of any of claims 5-7, wherein n is a real number satisfying 0 < n < 2.

9. The luminescent compound of any of claims 5, 6 or 8, wherein n is a real number satisfying 0 < n < 2, and m is 0.

10. The luminescent compound of any of claims 5-9, wherein the luminescent compound has a maximum photoluminescence wavelength of between 420 nanometers and 520 nanometers; and/or
wherein the luminescent compound has a full width at half maximum of 100 nanometers or less, when analyzed using photoluminescence spectroscopy.

11. A method of preparing a luminescent compound represented by Formula 1, the method comprising:
providing, onto a substrate, a mixture comprising at least one of an A¹-containing precursor or an A²-containing precursor, at least one of a B¹-containing precursor or a B²-containing precursor, and a solvent;
performing crystallization by adding an antisolvent to the mixture on the substrate; and
removing the solvent and the antisolvent from the mixture on the substrate by thermal treatment to prepare the luminescent compound represented by Formula 1,
Formula 1 [A¹ₙA²₍₃₋ₙ₎][B¹ₘB²₍₂₋ₘ₎]X₅
wherein, in Formula 1,
A¹ and A² are each independently at least one alkali metal, A¹ and A² being different from each other,
B¹ and B² are each independently, at least one element of Group 11, B¹ and B² being different from each other,
n is a real number satisfying 0 ≤ n ≤ 3,
m is a real number satisfying 0 ≤ m ≤ 2,
n and m are not zero at the same time,
3-n and 2-m are not zero at the same time, and
X is at least one halogen.

12. The method of claim 11, wherein a molar ratio of at least one of the A¹-containing precursor or the A²-containing precursor to at least one of the B¹-containing precursor or the B²-containing precursor is 3:2 to 4.5:2; and/or
wherein
the solvent is at least one of dimethyl formamide, dimethyl sulfoxide, γ-butyrolactone, or N-methyl-2-pyrrolidone, and the antisolvent is at least one of diethyl ether, toluene, α-terpineol, hexyl carbitol, butyl carbitol acetate, hexyl cellosolve, or butyl cellosolve acetate.

13. A light-emitting device comprising:
a first electrode;
a second electrode opposite to the first electrode; and
an emission layer interposed between the first electrode and the second electrode,
wherein the emission layer comprises the luminescent compound of any of claims 1-10.

14. The light-emitting device of claim 13, further comprising at least one of:
a hole transport region interposed between the first electrode and the emission layer, or
an electron transport region interposed between the emission layer and the second electrode.

15. The light-emitting device of claims 13 or 14, further comprising a charge control layer, wherein the charge control layer is between at least one of:
the first electrode and the emission layer, or
the emission layer and the second electrode.

## Patentansprüche

1. Lumineszierende Verbindung, dargestellt durch Formel 1:
Formel 1 [A¹ₙA²₍₃₋ₙ₎][B¹ₘB²_{(2-m)]}X₅
wobei, in Formel 1,
A¹ und A² jeweils unabhängig mindestens ein Alkalimetall sind, wobei A¹ und A² voneinander verschieden sind;
B¹ und B² jeweils unabhängig mindestens ein Element von Gruppe 11 sind, wobei B¹ und B² voneinander verschieden sind;
n eine reelle Zahl ist, die 0 ≤ n ≤ 3 erfüllt;
m eine reelle Zahl ist, die 0 ≤ m ≤ 2 erfüllt;
n und m nicht gleichzeitig null sind;
3-n und 2-m nicht gleichzeitig null sind; und
X mindestens ein Halogen ist.

2. Lumineszierende Verbindung nach Anspruch 1, wobei A¹ mindestens eines von Li, Na, K oder Rb ist und A² Cs ist;
vorzugsweise, wobei A¹ mindestens eines von Li, Na oder K ist und A² Cs ist.

3. Lumineszierende Verbindung nach Ansprüchen 1 oder 2, wobei B¹ und B² jeweils unabhängig mindestens eines von Cu, Ag oder Au sind;
vorzugsweise, wobei B¹ vorzugsweise mindestens eines von Au oder Ag ist und B² Cu ist.

4. Lumineszierende Verbindung nach einem der Ansprüche 1-3, wobei n eine reelle Zahl ist, die 0 < n < 3 erfüllt, oder m eine reelle Zahl ist, die 0 < m < 2 erfüllt; und/oderwobei X 1 ist.

5. Lumineszierende Verbindung nach einem der Ansprüche 1-4, wobei die lumineszierende Verbindung dargestellt ist durch eine Verbindung der Formel 1-1:
Formel 1-1 [A¹ₙCs₍₃₋ₙ₎][B¹ₘCu₍₂₋ₘ₎]X₅
wobei, in Formel 1-1,
A¹ mindestens ein sich von Cs unterscheidendes Alkalimetall ist;
B¹ mindestens ein sich von Cu unterscheidendes Element von Gruppe 11 ist;
n eine reelle Zahl ist, die 0 ≤ n ≤ 3 erfüllt;
m eine reelle Zahl ist, die 0 ≤ m ≤ 2 erfüllt;
n und m nicht gleichzeitig null sind;
3-n und 2-m nicht gleichzeitig null sind; und
X mindestens ein Halogen ist.

6. Lumineszierende Verbindung nach Anspruch 5, wobei A¹ mindestens eines von Na oder K ist.

7. Lumineszierende Verbindung nach Ansprüchen 5 oder 6, wobei n eine reelle Zahl ist, die 0 < n < 3 erfüllt, oder m eine reelle Zahl ist, die 0 < m < 2 erfüllt.

8. Lumineszierende Verbindung nach einem der Ansprüche 5-7, wobei n eine reelle Zahl ist, die 0 < n < 2 erfüllt.

9. Lumineszierende Verbindung nach einem der Ansprüche 5, 6 oder 8, wobei n eine reelle Zahl ist, die 0 < n < 2 erfüllt, und m 0 ist.

10. Lumineszierende Verbindung nach einem der Ansprüche 5-9, wobei die lumineszierende Verbindung eine maximale Photolumineszenzwellenlänge von zwischen 420 Nanometer und 520 Nanometer aufweist; und/oder
wobei die lumineszierende Verbindung eine volle Breite bei halbem Maximum von 100 Nanometer oder weniger aufweist, wenn unter Verwendung von Photolumineszenz-Spektroskopie analysiert.

11. Verfahren zur Herstellung einer durch Formel 1 dargestellten lumineszierenden Verbindung, wobei das Verfahren umfasst:
Bereitstellen, auf einem Substrat, eines Gemischs, das mindestens einen von einem A¹-haltigen Vorläufer oder einem A²-haltigen Vorläufer, mindestens einen von einem B¹-haltigen Vorläufer oder einem B²-haltigen Vorläufer und ein Lösungsmittel umfasst;
Durchführen einer Kristallisation durch Zugabe eines Antilösungsmittels zu dem Gemisch auf dem Substrat; und
Entfernen des Lösungsmittels und des Antilösungsmittels aus dem Gemisch auf dem Substrat durch Wärmebehandlung, zum Herstellen der lumineszierenden Verbindung, die dargestellt ist durch Formel 1,
Formel 1 [A¹ₙA²₍₃₋ₙ₎][B¹ₘB²_{(2-m)]}X₅
wobei, in Formel 1,
A¹ und A² jeweils unabhängig ein Alkalimetall sind, wobei A¹ und A² voneinander verschieden sind,
B¹ und B² jeweils unabhängig mindestens ein Element von Gruppe 11 sind, wobei B¹ und B² voneinander verschieden sind,
n eine reelle Zahl ist, die 0 ≤ n ≤ 3 erfüllt;
m eine reelle Zahl ist, die 0 ≤ m ≤ 2 erfüllt;
n und m nicht gleichzeitig null sind,
3-n und 2-m nicht gleichzeitig null sind und
X mindestens ein Halogen ist.

12. Verfahren nach Anspruch 11, wobei ein Molverhältnis von mindestens einem des A¹-haltigen Vorläufers oder des A²-haltigen Vorläufers zu mindestens einem des B¹-haltigen Vorläufers oder des B²-haltigen Vorläufers 3:2 bis 4,5:2 ist; und/oder
wobei
das Lösungsmittel mindestens eines von Dimethylformamid, Dimethylsulfoxid, γ-Butyrolacton oder N-Methyl-2-pyrrolidon ist und das Antilösungsmittel mindestens eines von Diethylether, Toluol, α-Terpineol, Hexylcarbitol, Butylcarbitolacetat, Hexylcellosolv oder Butylcellosolvacetat ist.

13. Lichtemittierende Vorrichtung, umfassend:
eine erste Elektrode;
eine zweite Elektrode gegenüber der ersten Elektrode; und
eine Emissionsschicht, die zwischen der ersten Elektrode und der zweiten Elektrode angeordnet ist,
wobei die Emissionsschicht die lumineszierende Verbindung nach einem der Ansprüche 1-10 umfasst.

14. Lichtemittierende Vorrichtung nach Anspruch 13, ferner umfassend mindestens einen von:einem Lochtransportbereich, der zwischen der ersten Elektrode und der Emissionsschicht angeordnet ist, oder
einem Elektronentransportbereich, der zwischen der Emissionsschicht und der zweiten Elektrode angeordnet ist.

15. Lichtemittierende Vorrichtung nach Ansprüchen 13 oder 14, ferner umfassend eine Ladungssteuerschicht, wobei die Ladungssteuerschicht zwischen mindestens einer von folgenden ist:
der ersten Elektrode und der Emissionsschicht, oder
der Emissionsschicht und der zweiten Elektrode.

## Revendications

1. Composé luminescent représenté par la formule 1 :
Formule 1 [A¹ₙA²₍₃₋ₙ₎][B¹ₘB²_{(2-m)]}X₅
avec, dans la formule 1,
A¹ et A² sont chacun indépendamment au moins un métal alcalin, A¹ et A² étant différents l'un de l'autre ;
B¹ et B² sont chacun indépendamment au moins un élément du groupe 11, B¹ et B² étant différents l'un de l'autre ;
n est un nombre réel satisfaisant à 0 ≤ n ≤ 3 ;
m est un nombre réel satisfaisant à 0 ≤ m ≤ 2 ;
n et m ne sont pas zéro en même temps ;
3-n et 2-m ne sont pas zéro en même temps ; et
X est au moins un halogène.

2. Composé luminescent de la revendication 1, dans lequel A¹ est au moins un parmi Li, Na, K ou Rb, et A² est Cs ;
de préférence dans lequel A¹ est au moins un parmi Li, Na ou K, et A² est Cs.

3. Composé luminescent des revendications 1 ou 2, dans lequel B¹ et B² sont chacun indépendamment au moins un parmi Cu, Ag, ou Au ;
de préférence dans lequel B¹ est au moins un parmi Au ou Ag, et B² est Cu.

4. Composé luminescent de l'une quelconque des revendications 1 à 3, dans lequel n est un nombre réel satisfaisant à 0 < n < 3, ou m est un nombre réel satisfaisant à 0 < m < 2 ; et/ou dans lequel X est I.

5. Composé luminescent de l'une quelconque des revendications 1 à 4, le composé luminescent étant représenté par un composé de formule 1-1 :
Formule 1-1 [A¹ₙCs₍₃₋ₙ₎][B¹ₘCu₍₂₋ₘ₎]X₅
avec dans la formule 1-1,
A¹ est au moins un métal alcalin différent de Cs ;
B¹ est au moins un élément du groupe 11 différent de Cu ;
n est un nombre réel satisfaisant à 0 ≤ n ≤ 3 ;
m est un nombre réel satisfaisant à 0 ≤ m ≤ 2 ;
n et m ne sont pas zéro en même temps ;
3-n et 2-m ne sont pas zéro en même temps ; et
X est au moins un halogène.

6. Composé luminescent de la revendication 5, dans lequel A¹ est au moins un parmi Na ou K.

7. Composé luminescent des revendications 5 ou 6, dans lequel n est un nombre réel satisfaisant à 0 < n < 3, ou m est un nombre réel satisfaisant à 0 < m < 2.

8. Composé luminescent de l'une quelconque des revendications 5 à 7, dans lequel n est un nombre réel satisfaisant à 0 < n < 2.

9. Composé luminescent de l'une quelconque des revendications 5, 6 ou 8, dans lequel n est un nombre réel satisfaisant à 0 < n < 2, et m est 0.

10. Composé luminescent de l'une des revendications 5 à 9, le composé luminescent comportant une longueur d'onde de photoluminescence maximale comprise entre 420 nanomètres et 520 nanomètres ; et/ou
le composé luminescent comportant une pleine largeur au demi maximum de 100 nanomètres ou moins, lorsqu'il est analysé par spectroscopie de photoluminescence.

11. Procédé de préparation d'un composé luminescent représenté par la formule 1, le procédé comprenant :
la fourniture, sur un substrat, d'un mélange comprenant au moins un parmi un précurseur contenant A¹ ou un précurseur contenant A², au moins un précurseur contenant B¹ ou un précurseur contenant B², et un solvant ;
la réalisation d'une cristallisation en ajoutant un antisolvant au mélange sur le substrat ; et
l'élimination du solvant et de l'antisolvant du mélange sur le substrat par traitement thermique pour préparer le composé luminescent représenté par la formule 1,
Formule 1 [A¹ₙA²₍₃₋ₙ₎][B¹ₘB²₍₂₋ₘ₎]X₅
avec, dans la formule 1,
A¹ et A² sont chacun indépendamment, au moins un métal alcalin, A¹ et A² étant différents l'un de l'autre,
B¹ et B² sont chacun indépendamment, au moins un élément du groupe 11, B¹ et B² étant différents l'un de l'autre,
n est un nombre réel satisfaisant à 0 ≤ n ≤ 3,
m est un nombre réel satisfaisant à 0 ≤ m ≤ 2,
n et m ne sont pas zéro en même temps,
3-n et 2-m ne sont pas zéro en même temps, et
X est au moins un halogène.

12. Procédé de la revendication 11, dans lequel un rapport molaire d'au moins un parmi le précurseur contenant A¹ ou le précurseur contenant A² à au moins le précurseur contenant B¹ ou le précurseur contenant B² est de 3:2 à 4,5:2 ; et/ou
dans lequel
le solvant est au moins un parmi diméthylformamide, diméthylsulfoxyde, γ- butyrolactone ou N-méthyl-2-pyrrolidone, et l'antisolvent est au moins un parmi éther diéthylique, toluène, α-terpinéol, carbitol hexylique, acétate de butyle et de carbitol, hexyl cellosolve ou acétate de butyl cellosolve.

13. Dispositif électroluminescent comprenant :
une première électrode ;
une seconde électrode opposée à la première électrode ; et
une couche d'émission interposée entre la première électrode et la seconde électrode,
dans lequel la couche d'émission comprend le composé luminescent de l'une quelconque des revendications 1 à 10.

14. Dispositif électroluminescent de la revendication 13, comprenant en outre au moins un parmi : une région de transport de trous interposée entre la première électrode et la couche d'émission, ou
une région de transport d'électrons interposée entre la couche d'émission et la seconde électrode.

15. Dispositif électroluminescent des revendications 13 ou 14, comprenant en outre une couche de contrôle de charge, dans lequel la couche de contrôle de charge est entre au moins une parmi :
la première électrode et la couche d'émission, ou
la couche d'émission et la seconde électrode.
